# EUROPEAN PATENT APPLICATION

(11) **EP 3 462 620 A1**
(43) Date of publication of application: **03.04.2019**
(21) Application number: 17193490.4
(22) Date of filing: 27.09.2017
(51) Int. Cl.: H03M 7/30, H04B 7/0456, H04B 7/06, H04B 7/08, H04L 29/08, H04L 5/00

(54) **HYBRID BEAMFORMING SYSTEM**

(71) Applicant: Deutsche Telekom AG, 53113 Bonn (DE); Technische Universität Darmstadt, 64289 Darmstadt (DE)
(72) Inventor: Belschner, Jakob, 60322 Frankfurt am Main (DE); Pesavento, Marius, 64283 Darmstadt (DE)
(74) Representative: Patentship Patentanwaltsgesellschaft mbH

(57) **Abstract**

The disclosure relates to a hybrid beamforming system (200), comprising: a set of digital Radio Frequency, RF, transceiver chains (201) configured to process an RF signal (200a, 200b); a bank of analog beamformers (203), coupled to the set of digital RF transceiver chains (201), and configured to beamform the RF signal (202a, 202b) in an analog RF domain; a multiple-input multiple-output, MIMO, antenna array (205), coupled to the bank of analog beamformers (203), and configured to transceive the beamformed RF signal (204) over a MIMO channel (105), in particular a massive MIMO channel; and a mixing network (207) comprising a known frequency selective mixing matrix (208), switchable between the set of digital RF transceiver chains (201) and the bank of analog beamformers (203), wherein the set of digital RF transceiver chains (201) is configured to estimate channel parameters of the MIMO channel (105) based on a pre-defined pilot transmission and the mixing matrix (208) of the mixing network (207) switched between the set of digital RF transceiver chains (201) and the bank of analog beamformers (203).

## Description

### TECHNICAL FIELD

In general, the invention relates to wireless communication networks and beamforming. More specifically, the invention relates to a hybrid beamforming (BF) system and a method for hybrid beamforming. This is especially relevant for massive Multiple Input Multiple Output (MIMO) systems.

### BACKGROUND

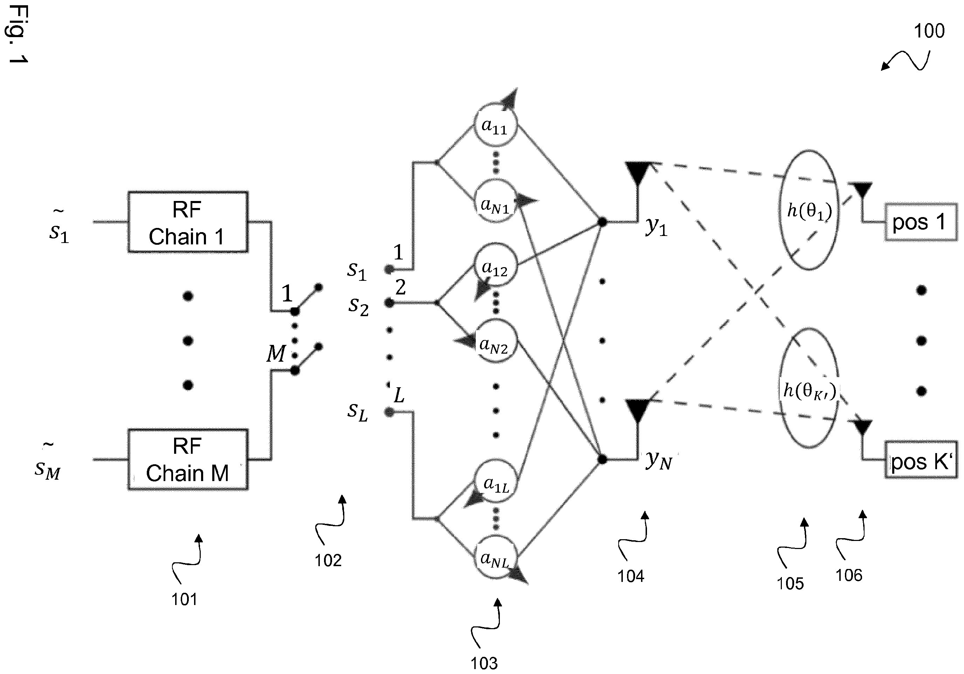

In hybrid BF systems 100, e.g. as shown in Fig. 1, the number M of RF (radio frequency) processing chains 101 is smaller than the number N of Rx (Receive) antennas 104 and generally also smaller than the number L of analogue BFs 103 in the codebook (M < L <<N). Therefore, in operation mode the RF chains 101 need to be connected to selected analogue BF outputs through switches 102 as shown in Fig. 1. In order to acquire full CSI (channel state information) of the channel H 105 between the transmit antennas 106 of the users and the receive antenna array 104 of the base station, (or alternatively the channel between all transmitters and the analogue BF outputs), it is therefore generally necessary to perform training over multiple time slots. In each time slot of the training phase a different analogue BF is connected to the RF receiver chains 101. This allows acquisition of the beamformed channels as a basis for selection. If the numbers N or L are much larger than M then the training time/overhead required is prohibitively large. In particular, during this training time, the channel H 105 may have changed due to fading and other effects.

### SUMMARY OF THE INVENTION

It is an object of the invention to provide a solution for an improved hybrid beamforming system. In particular, it is an object of the invention to improve the efficiency of the time and resource costly training and channel estimation procedure for the hybrid beamforming system as described above.

The foregoing and other objects are achieved by the subject matter of the independent claims. Further implementation forms are apparent from the dependent claims, the description and the figures.

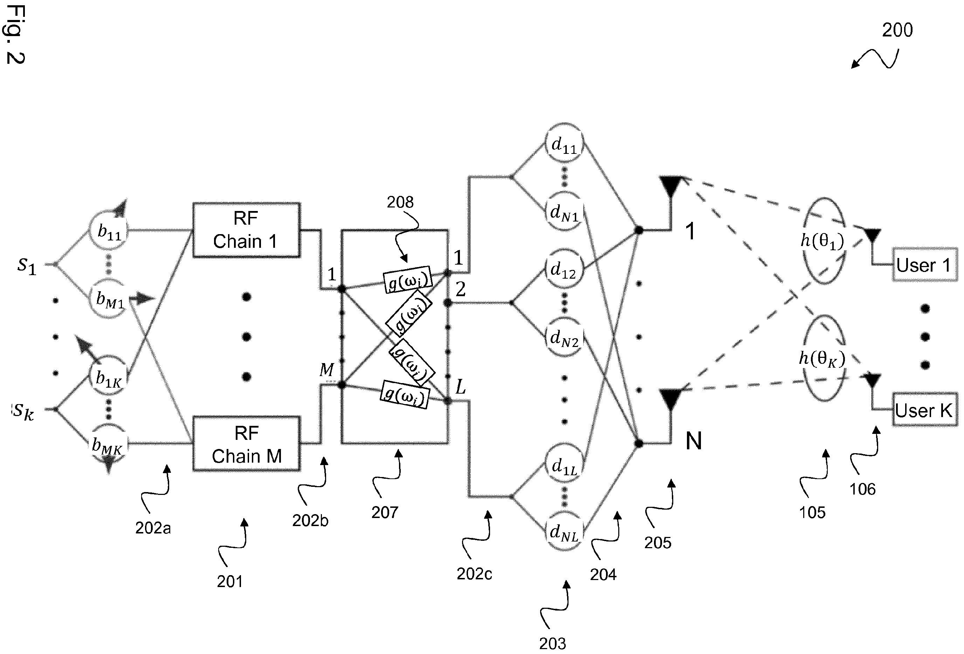

A basic concept of the disclosure is improving the efficiency of the time and resource costly training and channel estimation procedure by using a frequency selective mixing network, e.g. an L x M mixing network as described below with respect to Figure 2, with a frequency dependent L x M mixing matrix G(jω) that is primarily used for the channel estimation and to carry out the training in a single time slot.

The hybrid beamforming system as described in the following can acquire downlink channel state information from uplink pilot transmission. This provides the advantage that the uplink channels of the different users are known in the base station. The base station can control the user terminals by the channel state information, CSI. In particular for massive MIMO systems, the disclosed hybrid beamforming system provides a technique for an easy and cost efficient acquisition of CSI.

Embodiments of the present invention can be applied in MIMO (multiple input multiple output) systems, in particular in massive MIMO systems. In radio systems, multiple-input and multiple-output, or MIMO, is a method for multiplying the capacity of a radio link using multiple transmit and receive antennas to exploit multipath propagation. MIMO has become an essential element of wireless communication standards including IEEE 802.11n (Wi-Fi), IEEE 802.11ac (Wi-Fi), HSPA+ (3G), WiMAX (4G), Long Term Evolution (4G) and 5G New Radio (NR).

Embodiments of the present invention relate to beamforming systems, in particular hybrid beamforming systems, applicable for MIMO and massive MIMO (multiple input multiple output) systems. In massive or large scale MIMO systems the number of transmit/receive antennas at the base station is scaled up by one or two orders of magnitude as compared to current LTE and LTE-A networks. The massive increase of the spatial (antenna) dimensions in combination with the high number of antenna elements provides effective means to spatially separate users and to avoid inner- and intra-cell interference, while at the same time the effects of the random variability of the channel (fast small scale fading) are limited. Massive MIMO promises dramatic increases in the achievable data rates (linear scale with the number of users) and large simplifications in the network operation. This is achieved by linear transceiver techniques such as transmit/receive beamforming (spatial filtering) in which the antenna signals are linearly weighted with complex-valued beamforming coefficients (gain and phase) in the baseband with the objective to increase the useful signal power and to suppress the noise and interference power at the receivers. Beamforming requires the availability of precise channel state information available at the base station.

While in massive MIMO networks, multiuser data rates are increased and system overheads for opportunistic channel access, such as CSI (channel state information) feedback and link adaptation procedure, are reduced, the hardware costs associated with the large increase in number of antennas are extremely high. The hardware costs are mainly driven by the increase in the number of digital RF transceiver chains, i.e., the number of low noise power amplifiers, RF mixers and analog-to-digital and digital-to-analog converters, rather than the increase in the number of (hardware) antennas. To reduce these costs hybrid analog-digital MIMO systems have been proposed in which a bank of switchable (or electronically steerable) analog phase shifters (analog beamformers) are used to carry out part of the linear processing (beamforming) in the (analog) RF domain. The objective is to reduce the number of required digital RF transceiver chains while retaining most of the benefits of a large antenna array. Hybrid beamforming networks can be considered as a cascaded beamforming system in which only part of the linear processing is performed in the digital baseband and the other part of the processing is performed in the (analog) RF domain. Hybrid beamforming networks can be used in both the uplink and in the downlink. Channels state information (CSI) can be acquired for the downlink transmission in an FDD massive MIMO system. In these networks, downlink CSI is acquired from uplink pilot transmissions assuming channel reciprocity.

Embodiments of the present invention relate to compressed sensing techniques for application in beamforming systems. Compressed sensing, also known as compressive sensing, compressive sampling, or sparse sampling, describes a signal processing technique for efficiently acquiring and reconstructing a signal, by finding solutions to underdetermined linear systems. This is based on the principle that, by optimization, the sparsity of a signal can be exploited to recover it from far fewer samples than required by the Shannon-Nyquist sampling theorem.

In massive hybrid beamforming networks, acquiring precise channels state information at the base station about the channel between the physical antennas of the base station and the antennas of the users is a challenging task. This stems from the fact that in the uplink training the antennas of signals received at the physical antennas are not sampled directly and only samples at the output of the analog beamformers are available. However, as the number of receiver chains at the output of the analog beamformers is generally much smaller than the number of antennas, these samples represent underdetermined linear combinations of the antenna signal, i.e. the measurements form a linear system with more unknowns than equations. Recovering the antenna signal is the main challenge in the channel estimation task. Perfect recovery of the signals from underdetermined (spatially undersampled) linear combinations can however be achieved, based on the concept of compressed sensing, if the underlying signal model is sparse in some domain, i.e, if the signals can be characterized by a few discrete components, e.g., discrete multipath components that are resolved according to directions-of-departure/arrival, time-delays, and the Doppler shifts.

Hybrid beamforming systems as described in the following are applicable for wireless transmission, e.g. using wireless communication technologies, such as Universal Mobile Telecommunication System (UMTS, 3G) based on basic wideband-code division multiple access (W-CDMA), high-speed packet access (HSPA), Long Term Evolution (LTE), LTE-Advanced, and/or 5G system as well as NB IoT technology for instance, narrowband LTE, narrowband M2M, and narrowband OFDMA techniques.

In embodiments of the present invention, beamforming systems may be capable of transmitting and receiving content, data, information and/or signals via a wireless medium or channel. In some embodiments, the wireless medium may include, for example, a radio channel, a cellular channel, an RF channel, a WiFi channel, an IR channel, a Bluetooth (BT) channel, a Global Navigation Satellite System (GNSS) channel, and the like.

In embodiments of the present invention beamforming systems may include one or more radio modules (or short radios) including circuitry and/or logic to perform wireless communication between communication devices. In embodiments of the present invention the radio modules may include one or more wireless radio receivers (Rx) including circuitry and/or logic to receive wireless communication signals, RF signals, frames, blocks, transmission streams, packets, messages, data items, and/or data. In embodiments of the present invention the radio modules may include one or more wireless radio transmitters (Tx) including circuitry and/or logic to transmit wireless communication signals, RF signals, frames, blocks, transmission streams, packets, messages, data items, and/or data. In embodiments of the present invention, the radio modules may include Radio Frequency (RF) elements, baseband elements, modulation elements, demodulation elements, amplifiers, analog to digital and/or digital to analog converters, filters and the like, which can be implemented in hardware and/or software.

In embodiments of the present invention the radio modules may be configured to communicate according to an OFDM scheme and/or an FDMA scheme in an uplink direction and/or a downlink direction. In embodiments of the present invention the radio modules may be configured to communicate according to a FDD massive MIMO communication scheme. In other embodiments, the radios of the communication devices may be configured to communicate according to any other additional or alternative modulation scheme. In embodiments of the present invention, the radios may include, or may be associated with, one or more antennas. In one example, a communication device may include a single antenna. In another example, a communication device may include two or more antennas. Such antennas may include any type of antennas suitable for transmitting and/or receiving wireless communication signals, blocks, frames, transmission streams, packets, messages and/or data. The antennas may include, for example, antennas suitable for directional communication using beamforming techniques. For example, the antennas may include a phased array antenna, a multiple element antenna, a set of switched beam antennas, and/or the like. In some embodiments, the antennas may implement transmit and receive functionalities using separate transmit and receive antenna elements. In some embodiments, the antennas may implement transmit and receive functionalities using common and/or integrated transmit/receive elements.

According to a first aspect the invention relates to a hybrid beamforming system, comprising: a set of digital Radio Frequency, RF, transceiver chains configured to process an RF signal in digital domain; a bank of analog beamformers, coupled to the set of digital RF transceiver chains, and configured to beamform the RF signal in an analog RF domain; a multiple-input multiple-output, MIMO, antenna array, coupled to the bank of analog beamformers, and configured to transceive the beamformed RF signal over a MIMO channel, in particular a massive MIMO channel; and a mixing network comprising a known frequency selective mixing matrix, switchable between the set of digital RF transceiver chains and the bank of analog beamformers, wherein the set of digital RF transceiver chains is configured to estimate channel parameters of the MIMO channel based on a pre-defined pilot transmission and the mixing matrix of the mixing network switched between the set of RF transceiver chains and the bank of analog beamformers. Such a hybrid beamforming system provides a solution for an improved hybrid beamforming. Efficiency of the time and resource costly training and channel estimation procedure can be improved. The efficiency is improved by using a frequency selective mixing network with a frequency dependent mixing matrix which is primarily used for the channel estimation and to carry out the training in a single time slot.

In an implementation form of the hybrid beamforming system, the set of RF transceiver chains is configured to estimate the channel parameters of the MIMO channel within a single time slot of the pilot transmission.

By the mixing matrix each output of the set of RF transceiver chains is connected with each input of the bank of analog beamformers. Hence, a single measurement within a single time slot of pilot transmission is sufficient to acquire all information to estimate the channel parameters (within a single shot).

In an implementation form of the hybrid beamforming system, a number M of digital RF transceiver chains of the set of digital RF transceiver chains is smaller than a number of analog beamformers of the bank of analog beamformers; and the number L of analog beamformers is smaller than a number N of antennas of the MIMO antenna array.

This provides the advantage that costly digital RF transceiver chains can be saved. The solution can be efficiently applied in massive MIMO networks with massive MIMO antenna arrays.

In an implementation form of the hybrid beamforming system, the mixing network comprises a set of frequency selective elements interconnecting inputs of the mixing network with outputs of the mixing network to form the mixing matrix of the mixing network.

This provides the advantage that each path of the mixing network has a different frequency response which enables accurate channel estimation without generating interference between the different paths.

In an implementation form of the hybrid beamforming system, the set of frequency selective elements comprise sub-band filters to implement the frequency selective characteristics of the mixing network.

Sub-band filters can easily be implemented. There a various standard implementations of sub-band filter design.

In an implementation form of the hybrid beamforming system, the mixing network is configured to linearly combine all outputs of the bank of analog beamformers using different linear combinations in each frequency band.

This provides the advantage that the equation system for determining the channel parameters can be easily solved as different linear combinations exist for each frequency band.

In an implementation form of the hybrid beamforming system, the set of digital RF transceiver chains is configured to estimate the channel parameters of the MIMO channel based on the known mixing matrix using compressed sensing techniques.

These compressed sensing techniques reduce complexity of the solution, as the system matrix is modeled as a sparse matrix. I.e., a Iot of zeros exist in the system matrix which facilitates finding a solution for channel estimation.

In an implementation form of the hybrid beamforming system, the set of digital RF transceiver chains is configured to estimate the channel parameters of the MIMO channel based on uplink pilot transmission.

This provides the solution that known pilots can be transmitted in uplink direction. By assuming channel reciprocity, the same channel parameters apply in both uplink and downlink direction. Channel estimation in downlink direction can be saved as the result is the same as for channel estimation in uplink direction.

In an implementation form, the hybrid beamforming system, comprises: a controller, configured to switch the mixing network between the set of digital RF transceiver chains and the bank of analog beamformers for channel estimation in uplink transmission.

The controller enables to switch the hybrid beamforming system according to different scenarios. Thus, the controller provides flexibility of the system.

In an implementation form of the hybrid beamforming system, the controller is configured to switch the set of digital RF transceiver chains to the bank of analog beamformers via the mixing network or by traversing the mixing network for downlink transmission.

This provides the advantage that the controller can control and enable different scenarios, for example uplink transmission with or without mixing network and/or downlink transmission with or without mixing network.

In an implementation form of the hybrid beamforming system, the set of digital RF transceiver chains is configured to acquire downlink channel state information from uplink pilot transmission.

This provides the advantage that the uplink channels of the different users are known in the base station. The base station can control the user terminals by the channel state information, CSI. For MIMO systems, in particular for massive MIMO systems, the disclosed hybrid beamforming system provides a technique for an easy and cost efficient acquisition of CSI by using the mixing network.

In an implementation form of the hybrid beamforming system, the set of digital RF transceiver chains comprises low noise power amplifiers, RF mixers, analog-to-digital converters and digital-to-analog converters.

This provides the advantage that due to the mixing network a low number of such devices can be implemented which saves resources. The mixing network facilitates an efficient acquisition of channel state information, CSI. Without such a mixing network, it is hardly possible to access the CSI.

In an implementation form, the hybrid beamforming system comprises: a set of subband power measurement elements, configured to determine subband power measurements, when the mixing network is switched between the set of subband power measurement elements and the bank of analog beamformers, and the channel parameters of the MIMO channel are determined based on the subband power measurements.

This provides the advantage that these power measurements can be easily implemented and allow high accuracy measurements. The subband power measurement elements can be implemented less complex than the digital RF chains, so a larger number of subband power measurement elements can be installed allowing to increase measurement accuracy. The power measurements can be provided additional to the digital RF chains.

In an implementation form of the hybrid beamforming system, the mixing network comprises a number of L inputs corresponding to a number of analog beamformers of the bank of analog beamformers and a number of K outputs corresponding to a number of subband power measurement elements, and the number K of subband power measurement elements is larger than a number M of digital RF transceiver chains of the set of digital RF transceiver chains.

This provides the advantage that due to the reduced complexity of the subband power measurement elements a larger number of these elements can be installed, thereby resulting in a higher measurement accuracy.

According to a second aspect, the invention relates to a method for hybrid beamforming, the method comprising: transceiving a Radio Frequency, RF signal over a multiple-input multiple-output (MIMO) channel, in particular a massive MIMO channel; beamforming the RF signal in an analog RF domain, by a bank of analog beamformers; processing the RF signal by a set of digital RF transceiver chains; and estimating channel parameters of the MIMO channel based on a pre-defined pilot transmission and a known frequency selective mixing matrix of a mixing network coupled between the set of digital RF transceiver chains and the bank of analog beamformers.

When performing the steps of the method in the above-indexed sequence, the method describes Uplink (UL) beamforming. For Downlink (DL) beamforming the steps of the method may be performed in reverse direction, i.e.: processing a Radio Frequency, RF, signal by a set of digital RF transceiver chains; beamforming the RF signal in an analog RF domain, by a bank of analog beamformers; and transceiving the beamformed RF signal over a multiple-input multiple-output, MIMO, channel, in particular a massive MIMO channel. The mixing network 207 may optionally be included for DL beamforming.

Such a method provides a solution for an improved hybrid beamforming. Efficiency of the time and resource costly training and channel estimation procedure can be improved. The efficiency is improved by using a frequency selective mixing network with a frequency dependent mixing matrix which is primarily used for the channel estimation and to carry out the training in a single time slot.

In an implementation form of the method, the method comprises: switching the mixing network between the set of digital RF transceiver chains and the bank of analog beamformers.

This step allows applying different scenarios for data transmission in uplink and/or downlink depending on the mixing network switched or not switched into the system which results in flexibility.

According to a third aspect the invention relates to a hybrid beamformer, comprising: a bank of analog beamformers configured to beamform an RF signal in an analog RF domain; a set of digital RF transceiver chains configured to process the RF signal in a digital domain; and a mixing network comprising a known frequency selective mixing matrix, switchable between the set of digital RF transceiver chains and the bank of analog beamformers, wherein the set of digital RF transceiver chains is configured to estimate channel parameters of a channel, in particular a MIMO channel, in particular a massive MIMO channel, based on a pre-defined pilot transmission and the mixing matrix of the mixing network switched between the set of digital RF transceiver chains and the bank of analog beamformers.

According to a fourth aspect the invention relates to a computer program product comprising program code for performing the method according to the second aspect of the invention, when executed on a computer or a processor.

Embodiments of the invention can be implemented in hardware and/or software.

### BRIEF DESCRIPTION OF THE DRAWINGS

Further embodiments of the invention will be described with respect to the following figures, wherein:
Fig. 1 shows a block diagram illustrating a conventional hybrid beamforming system 100;
Fig. 2 shows a block diagram illustrating a hybrid beamforming system 200 according to an embodiment; and
Fig. 3 shows a schematic diagram of a method 300 for hybrid beamforming according to an embodiment.

### DETAILED DESCRIPTION OF EMBODIMENTS

In the following detailed description, reference is made to the accompanying drawings, which form part of the disclosure, and in which are shown, by way of illustration, specific aspects in which the present invention may be placed. It is understood that other aspects may be utilized and structural or logical changes may be made without departing from the scope of the present invention. The following detailed description, therefore, is not to be taken in a limiting sense, as the scope of the present invention is defined by the appended claims.

For instance, it is understood that a disclosure in connection with a described method may also hold true for a corresponding device or system configured to perform the method and vice versa. For example, if a specific method step is described, a corresponding device may include a unit to perform the described method step, even if such unit is not explicitly described or illustrated in the figures. Further, it is understood that the features of the various exemplary aspects described herein may be combined with each other, unless specifically noted otherwise.

Fig. 1 shows a block diagram illustrating a conventional hybrid beamforming system 100. Signal propagation is from left to right, i.e. uplink reception is considered. The hybrid beamforming multiuser network 100 includes N receive/transmit antennas 104, 106, a bank of L analogue beamformers 103, a switching network 102 with L inputs and M outputs. The outputs of the switching network 102 are connected to the RF receiver chains 101, down-converted and sampled. During the training and channel estimation process different analogue BF 103 are connected to the RF chains 101 (the bank of BF 103 are stepped through). N> L > M is assumed. For example, a switching network 102 with L inputs and M outputs may require L times M transmissions of a training signal which may result in L times M time slot of a pilot transmission.

Fig. 2 shows a block diagram illustrating a hybrid beamforming system 200 according to an embodiment. Signal propagation is from left to right, i.e. uplink reception is considered in the embodiment described in the following. The users on the right side may represent the plurality of user equipments with their antennas 106 served by a base station. The elements on the left side, i.e. left from the transmission channel 105, may represent the elements in the base station. The hybrid beamforming system 200 represents a hybrid beamforming multiuser network with N receive/transmit antennas 205, a bank of L analogue beamformers 203, a mixing network 207 with L inputs and M outputs that is, e.g. characterized by transfer functions *g*(*jω*)*.* The outputs of the mixing network 207 are connected to the RF receiver chains 201, down-converted and sampled. In an exemplary implementation, the mixing network 207 is only connected for channel estimation purpose in the UL and not necessarily used in the DL operation. It is assumed that N > L > M.

The mixing network 207 may or may not be used for actual payload data transmission/reception. The input of the mixing network 207 is connected to the output of the analogue BF bank 203 and the wideband output of the mixing network 207 is sampled at Nyquist rate in the RF receiver chains 201. The mixing network 207 deliberately introduces frequency diversity in the sense that all the analogue BF outputs are linearly combined in the mixing network 207 using different linear combinations in each frequency band. The obtained frequency selective measurements enable the receiver to estimate the relevant channel parameters of the massive MIMO channel 105 (e.g. Destination of Arrival, DoA, Destination of Departure, DoD, Time Difference of Arrival, TDoA, Doppler and gains of propagation paths) based on the knowledge of *g*(*jω*) using, e.g., compressed sensing techniques.

Instead of sampling the outputs of the frequency selective mixing network 207 using M available RF receiver chains 201, in another embodiment of the hybrid beamforming system 200 (not illustrated in Fig. 2), an alternative procedure is applied using subband "power" measurements that involve a dedicated hardware connected to the mixing network 207. This dedicated hardware may include subband filters, integrators and sampling units. These subband power measurements can be realized in a cost efficient manner. The sampling rate of the power measurements is significantly lower than the symbol rates. Considering a number of K subband measurements to be recorded (K >>M). Then the mixing network 207 contains L inputs (from the analogue BF 203 outputs) and K outputs (low cost subband measurement devices). The parametric channel estimation is carried out based on the power measurements using, e.g., compressed sensing methods.

In a general representation, the hybrid beamforming system 200 shown in Fig. 2, comprises: a set of Radio Frequency, RF, transceiver chains 201 configured to process an RF signal 200a, 200b; a bank of analog beamformers 203, coupled to the set of digital RF transceiver chains 201, and configured to beamform the RF signal 202a, 202b in an analog RF domain; a multiple-input multiple-output, MIMO, antenna array 205, coupled to the bank of analog beamformers 203, and configured to transceive the beamformed RF signal 204 over a MIMO channel 105, in particular a massive MIMO channel; and a mixing network 207 comprising a known frequency selective mixing matrix 208, switchable between the set of digital RF transceiver chains 201 and the bank of analog beamformers 203. The set of digital RF transceiver chains 201 is configured to estimate channel parameters of the MIMO channel 105 based on a pre-defined pilot transmission and the mixing matrix 208 of the mixing network 207 switched between the set of digital RF transceiver chains 201 and the bank of analog beamformers 203.

The hybrid beamforming system 200 may transmit data in both directions. As described above, signal propagation from left to right corresponds to uplink reception for users 1 to K while signal propagation from right to left corresponds to downlink reception for the digital RF transceiver chains 201 which may be implemented in a base station together with the antenna array 205, the bank of analog beamformers 203 and the mixing network 207.

The set of digital RF transceiver chains 201 may be configured to estimate the channel parameters of the MIMO channel 105 within a single time slot of the pilot transmission. This is possible due to the mixing network 207 replacing the switching network 102 depicted in Fig. 1. The mixing network 207 couples all outputs of the bank of analog beamformers 203 to all inputs of the digital RF transceiver chains 201. Hence a single measurement is sufficient to estimate the channel parameters.

In an embodiment of the beamforming system 200, a number M of digital RF transceiver chains of the set of digital RF transceiver chains 201 may be smaller than a number L of analog beamformers of the bank of analog beamformers 203. The number L of analog beamformers may be smaller than a number N of antennas of the MIMO antenna array 205.

The mixing network 207 may comprise a set of frequency selective elements *g*(*jω*) interconnecting inputs of the mixing network 207 with outputs of the mixing network 207 to form the mixing matrix 208 of the mixing network 207. For example, inputs 1..L are interconnected through the mixing network 207 with outputs 1..M. The frequency selective elements *g*(*jω*) may be implemented with linear or non-linear filter functions. The set of frequency selective elements may, for example, comprise sub-band filters to implement the frequency selective characteristics of the mixing network 207.

The mixing network 207 may be configured to linearly combine all outputs of the bank of analog beamformers 203 using different linear combinations in each frequency band. Hence, each channel may be easily reconstructed for channel estimation.

The set of digital RF transceiver chains 201 may be configured to estimate the channel parameters of the MIMO channel 105 based on the known mixing matrix 208 using compressed sensing techniques. I.e., sparse channel estimation techniques may be applied modeling the channel as a model with sparsely occupied parameters in the channel matrix which reduces computational complexity.

The set of digital RF transceiver chains 201 may be configured to estimate the channel parameters of the MIMO channel 105 based on uplink pilot transmission. I.e. known pilot sequences are transmitted in uplink direction, i.e. from left to right, from which pilot sequences the channel parameters can be derived.

The hybrid beamforming system 200 may include a controller (not depicted in Fig. 2) that may be configured to switch the mixing network 207 between the set of digital RF transceiver chains 201 and the bank of analog beamformers 203 for channel estimation in uplink transmission. As described above, data transmission may be performed with or without mixing network 207. The controller can control and enable these different scenarios. The controller may be configured to switch the set of digital RF transceiver chains 201 to the bank of analog beamformers 203 via the mixing network 207 or by traversing the mixing network 207 for downlink transmission.

The set of digital RF transceiver chains 201 may be configured to acquire downlink channel state information from uplink pilot transmission, for example assuming channel reciprocity, i.e. channel parameters are equal in uplink and downlink direction.

The set of digital RF transceiver chains 201 may comprise low noise power amplifiers, RF mixers, analog-to-digital converters and digital-to-analog converters, e.g. for baseband signal processing in the digital domain.

In an alternative implementation as described above, the hybrid beamforming system 200 may comprise: a set of subband power measurement elements, configured to determine subband power measurements, when the mixing network 207 is switched between the set of subband power measurement elements and the bank of analog beamformers 203. The channel parameters of the MIMO channel 105 may be determined based on the subband power measurements. This set of subband power measurement elements may be switched to the terminals 1..M of the mixing network 207 additionally or alternatively to the digital RF transceiver chains 210. I.e., the beamforming system 200 may be implemented with the set of subband power measurement elements instead of the digital RF transceiver chains 201. In an alternative implementation, the beamforming system 200 may be implemented with both, the set of subband power measurement elements, and the digital RF transceiver chains 201.

The mixing network 207 may comprise a number of L inputs corresponding to a number of analog beamformers of the bank of analog beamformers 203 and a number of K outputs corresponding to a number of subband power measurement elements. The number K of subband power measurement elements may be larger than the number M of digital RF transceiver chains of the set of digital RF transceiver chains 201.

The bank of analog beamformers 203 may implement a first signal path from terminal 1 of the L (input) terminals of the mixing network 207 to each of the N antennas of the antenna array 206 via beamformers d₁₁ to d_{N1}, a second signal path from terminal 2 of the L (input) terminals of the mixing network 207 to each of the N antennas of the antenna array 206 via beamformers d₁₂ to d_{N2}, etc. and an L-th signal path from terminal L of the L (input) terminals of the mixing network 207 to each of the N antennas of the antenna array 206 via beamformers d_{1L} to d_{NL} as shown in Fig. 2. Each of these transmissions paths is coupled via the mixing network to each of the M terminals of the digital RF transceiver chains 201.

A further variation may be implemented by gain elements b₁₁, ..., b_{M1}, ..., b_{1K}, ..., b_{MK} shown in Fig. 2. Depending on these gain elements, a set of signals s₁, ..., sₖ may be provided to each digital RF transceiver chain of the set of digital RF transceiver chains 201, e.g. for downlink transmission.

In an embodiment, the bank of analog beamformers 203 and the set of digital RF transceiver chains 201 together with the mixing network 207 form a hybrid beamformer. Such a hybrid beamformer includes the bank of analog beamformers 203 which are configured to beamform an RF signal in an analog RF domain; the set of digital RF transceiver chains 201 which are configured to process the RF signal in a digital domain; and the mixing network 207 with the known frequency selective mixing matrix 208. The mixing network 207 is switchable between the set of digital RF transceiver chains 201 and the bank of analog beamformers 203. The set of digital RF transceiver chains 201 is configured to estimate channel parameters of the channel, in particular a MIMO channel 105, in particular a massive MIMO channel, based on a pre-defined pilot transmission and the mixing matrix 208 of the mixing network 207 when the mixing network 207 is switched between the set of digital RF transceiver chains 201 and the bank of analog beamformers 203.

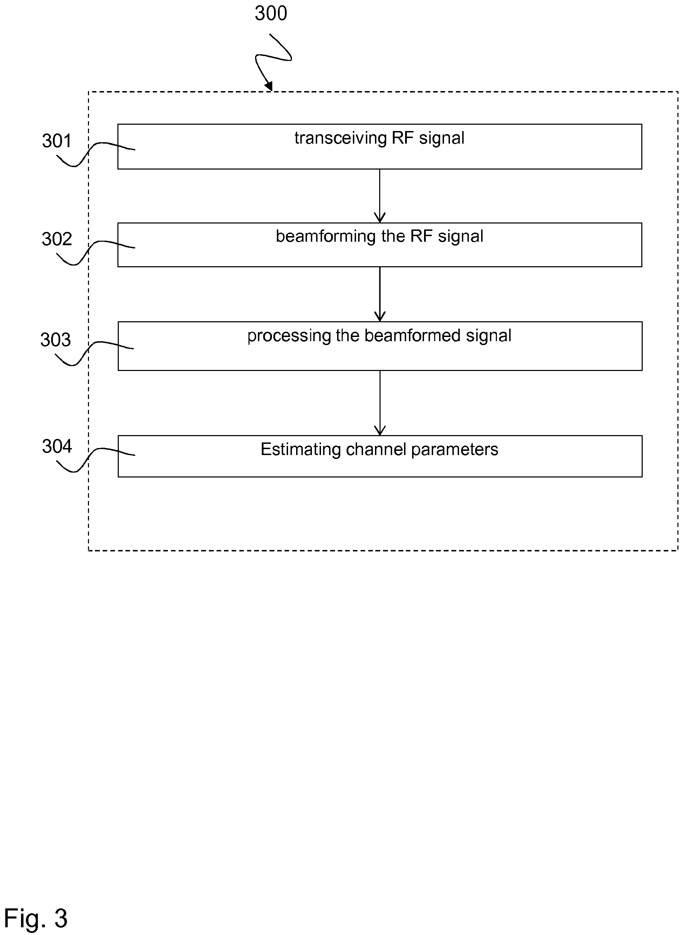

Fig. 3 shows a schematic diagram of a method 300 for hybrid beamforming according to an embodiment. The method 300 includes the following steps: transceiving 301 a Radio Frequency, RF, signal over a multiple-input multiple-output, MIMO, channel 105, in particular a massive MIMO channel, by a MIMO antenna array 205, e.g. as described above with respect to Fig. 2. The method 300 includes beamforming 302 the RF signal in an analog RF domain, by a bank of analog beamformers 203, e.g. beamformers 203 as described above with respect to Fig. 2. The method 300 further includes processing 303 the beamformed RF signal 202a, 202b by a set of RF transceiver chains, e.g. RF transceiver chains 201 as described above with respect to Fig. 2. The method 300 further includes estimating 304 channel parameters of the MIMO channel 105 based on a pre-defined pilot transmission and a known frequency selective mixing matrix 208 of a mixing network 207 coupled between the set of digital RF transceiver chains 201 and the bank of analog beamformers 203, e.g. as described above with respect to Fig. 2.

The method 300 may further include switching the mixing network 207 between the set of digital RF transceiver chains 201 and the bank of analog beamformers 203, e.g. as described above with respect to Fig. 2.

The steps of the method 300 may also performed in reverse direction to implement Downlink (DL) beamforming: processing a Radio Frequency, RF, signal by a set of digital RF transceiver chains; beamforming the RF signal in an analog RF domain, by a bank of analog beamformers; and transceiving the beamformed RF signal over a multiple-input multiple-output, MIMO, channel, in particular a massive MIMO channel. The mixing network 207 can optionally be included in the DL signal path.

Another aspect of the invention is related to a computer program product comprising program code for performing the method 300 described above, when executed on a computer or a processor. The method 300 may be implemented as program code that may be stored on a non-transitory computer medium.

While a particular feature or aspect of the disclosure may have been disclosed with respect to only one of several implementations or embodiments, such feature or aspect may be combined with one or more other features or aspects of the other implementations or embodiments as may be desired and advantageous for any given or particular application. Furthermore, to the extent that the terms "include", "have", "with", or other variants thereof are used in either the detailed description or the claims, such terms are intended to be inclusive in a manner similar to the term "comprise". Also, the terms "exemplary", "for example" and "e.g." are merely meant as an example, rather than the best or optimal. The terms "coupled" and "connected", along with derivatives may have been used. It should be understood that these terms may have been used to indicate that two elements cooperate or interact with each other regardless whether they are in direct physical or electrical contact, or they are not in direct contact with each other.

Although specific aspects have been illustrated and described herein, it will be appreciated by those of ordinary skill in the art that a variety of alternate and/or equivalent implementations may be substituted for the specific aspects shown and described without departing from the scope of the present disclosure. This application is intended to cover any adaptations or variations of the specific aspects discussed herein.

Although the elements in the following claims are recited in a particular sequence, unless the claim recitations otherwise imply a particular sequence for implementing some or all of those elements, those elements are not necessarily intended to be limited to being implemented in that particular sequence.

Many alternatives, modifications, and variations will be apparent to those skilled in the art in light of the above teachings. Of course, those skilled in the art readily recognize that there are numerous applications of the invention beyond those described herein. While the present invention has been described with reference to one or more particular embodiments, those skilled in the art recognize that many changes may be made thereto without departing from the scope of the present invention. It is therefore to be understood that within the scope of the appended claims and their equivalents, the invention may be practiced otherwise than as specifically described herein.

## Claims

1. A hybrid beamforming system (200), comprising:
a set of Radio Frequency, RF, digital transceiver chains (201) configured to process an RF signal (200a, 200b);
a bank of analog beamformers (203), coupled to the set of digital RF transceiver chains (201), and configured to beamform the RF signal (202a, 202b) in an analog RF domain;
a multiple-input multiple-output, MIMO, antenna array (205), coupled to the bank of analog beamformers (203), and configured to transceive the beamformed RF signal (204) over a MIMO channel (105), in particular a massive MIMO channel; and
a mixing network (207) comprising a known frequency selective mixing matrix (208), switchable between the set of digital RF transceiver chains (201) and the bank of analog beamformers (203),
wherein the set of digital RF transceiver chains (201) is configured to estimate channel parameters of the MIMO channel (105) based on a pre-defined pilot transmission and the mixing matrix (208) of the mixing network (207) switched between the set of digital RF transceiver chains (201) and the bank of analog beamformers (203).

2. The hybrid beamforming system (200) of claim 1,
wherein the set of digital RF transceiver chains (201) is configured to estimate the channel parameters of the MIMO channel (105) within a single time slot of the pilot transmission.

3. The hybrid beamforming system (200) of one of the preceding claims,
wherein the mixing network (207) comprises a set of frequency selective elements interconnecting inputs of the mixing network (207) with outputs of the mixing network (207) to form the mixing matrix (208) of the mixing network (207).

4. The hybrid beamforming system (200) of claim 3,
wherein the set of frequency selective elements comprise sub-band filters to implement the frequency selective characteristics of the mixing network (207).

5. The hybrid beamforming system (200) of one of the preceding claims,
wherein the mixing network (207) is configured to linearly combine all outputs of the bank of analog beamformers (203) using different linear combinations in each frequency band.

6. The hybrid beamforming system (200) of one of the preceding claims,
wherein the set of digital RF transceiver chains (201) is configured to estimate the channel parameters of the MIMO channel (105) based on the known mixing matrix (208) using compressed sensing techniques.

7. The hybrid beamforming system (200) of one of the preceding claims,
wherein the set of digital RF transceiver chains (201) is configured to estimate the channel parameters of the MIMO channel (105) based on uplink pilot transmission.

8. The hybrid beamforming system (200) of one of the preceding claims, comprising:
a controller, configured to switch the mixing network between the set of digital RF transceiver chains and the bank of analog beamformers for channel estimation in uplink transmission.

9. The hybrid beamforming system (200) of one of the preceding claims,
wherein the controller is configured to switch the set of digital RF transceiver chains to the bank of analog beamformers via the mixing network or by traversing the mixing network for downlink transmission.

10. The hybrid beamforming system (200) of one of the preceding claims,
wherein the set of digital RF transceiver chains (201) is configured to acquire downlink channel state information from uplink pilot transmission.

11. The hybrid beamforming system (200) of one of the preceding claims,
wherein the set of digital RF transceiver chains (201) comprises low noise power amplifiers, RF mixers, analog-to-digital converters and digital-to-analog converters.

12. The hybrid beamforming system (200) of one of the preceding claims, comprising:
a set of subband power measurement elements, configured to determine subband power measurements, when the mixing network (207) is switched between the set of subband power measurement elements and the bank of analog beamformers (203),
wherein the channel parameters of the MIMO channel (105) are determined based on the subband power measurements.

13. The hybrid beamforming system (200) of claim 12,
wherein the mixing network (207) comprises a number of L inputs corresponding to a number of analog beamformers of the bank of analog beamformers (203) and a number of K outputs corresponding to a number of subband power measurement elements, and
wherein the number K of subband power measurement elements is larger than a number M of digital RF transceiver chains of the set of digital RF transceiver chains (201).

14. A method (300) for hybrid beamforming, comprising:
transceiving (301) a Radio Frequency, RF, signal over a multiple-input multiple-output, MIMO, channel (105), in particular a massive MIMO channel;
beamforming (302) the RF signal in an analog RF domain, by a bank of analog beamformers (203);
processing (303) the RF signal (202a, 202b) by a set of digital RF transceiver chains (201); and
estimating (304) channel parameters of the MIMO channel (105) based on a pre-defined pilot transmission and a known frequency selective mixing matrix (208) of a mixing network (207) coupled between the set of digital RF transceiver chains (201) and the bank of analog beamformers (203).

15. The method (300) of claim 14, comprising:
switching the mixing network (207) between the set of digital RF transceiver chains (201) and the bank of analog beamformers (203).

## Amended claims

### Amended claims in accordance with Rule 137(2) EPC.

1. A hybrid beamforming system (200), comprising:
a set of Radio Frequency, RF, digital transceiver chains (201) configured to process an RF signal (200a, 200b);
a bank of analog beamformers (203), coupled to the set of digital RF transceiver chains (201), and configured to beamform the RF signal (202a, 202b) in an analog RF domain;
a multiple-input multiple-output, MIMO, antenna array (205), coupled to the bank of analog beamformers (203), and configured to transceive the beamformed RF signal (204) over a MIMO channel (105), in particular a massive MIMO channel;
a mixing network (207) comprising a known frequency selective mixing matrix (208), switchable between the set of digital RF transceiver chains (201) and the bank of analog beamformers (203),
wherein the set of digital RF transceiver chains (201) is configured to estimate channel parameters of the MIMO channel (105) based on a pre-defined pilot transmission and the mixing matrix (208) of the mixing network (207) switched between the set of digital RF transceiver chains (201) and the bank of analog beamformers (203); and
a controller, configured to switch the mixing network between the set of digital RF transceiver chains and the bank of analog beamformers for channel estimation in uplink transmission.

2. The hybrid beamforming system (200) of claim 1,
wherein the set of digital RF transceiver chains (201) is configured to estimate the channel parameters of the MIMO channel (105) within a single time slot of the pilot transmission.

3. The hybrid beamforming system (200) of one of the preceding claims,
wherein the mixing network (207) comprises a set of frequency selective elements interconnecting inputs of the mixing network (207) with outputs of the mixing network (207) to form the mixing matrix (208) of the mixing network (207).

4. The hybrid beamforming system (200) of claim 3,
wherein the set of frequency selective elements comprise sub-band filters to implement the frequency selective characteristics of the mixing network (207).

5. The hybrid beamforming system (200) of one of the preceding claims,
wherein the mixing network (207) is configured to linearly combine all outputs of the bank of analog beamformers (203) using different linear combinations in each frequency band.

6. The hybrid beamforming system (200) of one of the preceding claims,
wherein the set of digital RF transceiver chains (201) is configured to estimate the channel parameters of the MIMO channel (105) based on the known mixing matrix (208) using compressed sensing techniques.

7. The hybrid beamforming system (200) of one of the preceding claims,
wherein the set of digital RF transceiver chains (201) is configured to estimate the channel parameters of the MIMO channel (105) based on uplink pilot transmission.

8. The hybrid beamforming system (200) of one of the preceding claims,
wherein the controller is configured to switch the set of digital RF transceiver chains to the bank of analog beamformers via the mixing network or by traversing the mixing network for downlink transmission.

9. The hybrid beamforming system (200) of one of the preceding claims,
wherein the set of digital RF transceiver chains (201) is configured to acquire downlink channel state information from uplink pilot transmission.

10. The hybrid beamforming system (200) of one of the preceding claims,
wherein the set of digital RF transceiver chains (201) comprises low noise power amplifiers, RF mixers, analog-to-digital converters and digital-to-analog converters.

11. The hybrid beamforming system (200) of one of the preceding claims, comprising:
a set of subband power measurement elements, configured to determine subband power measurements, when the mixing network (207) is switched between the set of subband power measurement elements and the bank of analog beamformers (203),
wherein the channel parameters of the MIMO channel (105) are determined based on the subband power measurements.

12. The hybrid beamforming system (200) of claim 11,
wherein the mixing network (207) comprises a number of L inputs corresponding to a number of analog beamformers of the bank of analog beamformers (203) and a number of K outputs corresponding to a number of subband power measurement elements, and
wherein the number K of subband power measurement elements is larger than a number M of digital RF transceiver chains of the set of digital RF transceiver chains (201).

13. A method (300) for hybrid beamforming, comprising:
transceiving (301) a Radio Frequency, RF, signal over a multiple-input multiple-output, MIMO, channel (105), in particular a massive MIMO channel;
beamforming (302) the RF signal in an analog RF domain, by a bank of analog beamformers (203);
processing (303) the RF signal (202a, 202b) by a set of digital RF transceiver chains (201);
estimating (304) channel parameters of the MIMO channel (105) based on a pre-defined pilot transmission and a known frequency selective mixing matrix (208) of a mixing network (207) coupled between the set of digital RF transceiver chains (201) and the bank of analog beamformers (203); and
switching the mixing network (207) between the set of digital RF transceiver chains (201) and the bank of analog beamformers (203).
